# EUROPEAN PATENT APPLICATION

(11) **EP 4 353 864 A2**
(43) Date of publication of application: **17.04.2024**
(21) Application number: 23198553.2
(22) Date of filing: 20.09.2023
(51) Int. Cl.: C23C 16/40, C23C 16/455, C23C 16/56, H01L 21/02

(54) **HIGH-CRYSTALLINITY BARIUM TITANATE FILM STRUCTURE, METHOD OF PREPARATION AND APPLICATION THEREOF**

(30) Priority: 23.09.2022 CN 202211164144
(71) Applicant: LoMaRe Technologies Limited, London Greater London EC3R 7LP (GB); LoMaRe Chip Technology Changzhou Co., Ltd., Changzhou City Jiangsu (CN)
(72) Inventor: MIHAI, Andrei Paul, London EC3R 7LP (GB); ZOU, Bin, London EC3R 7LP (GB); ZEMEN, Jan, London EC3R 7LP (GB); DOLUI, Kapildeb, London EC3R 7LP (GB); YU, Fengzhi, Changzhou City (CN); SUN, Xudong, Changzhou City (CN)
(74) Representative: Cozens, Paul Dennis

(57) **Abstract**

The present invention provides a high-crystallinity barium titanate film structure, a method of preparation and an application thereof, and relates to the field of materials and devices. The method includes the steps of depositing, on a substrate, a barium titanate layer with a (001) or (111) crystal orientation by atomic layer deposition in a high vacuum environment and at a low temperature of 450°C or below, wherein a Ba/Ti ratio in the barium titanate layer is 0.9-1.5; and performing plasma annealing treatment on the barium titanate layer at a low temperature of 450°C or below without breaking vacuum to form a high-crystallinity barium titanate layer having the (001) or (111) crystal orientation. The film structure may further comprise top and bottom electrodes formed above and below the barium titanate layer. The present invention solves the problem that an existing method for obtaining a crystalline BTO film is not applicable to back-end of line (BEOL) integration processes.

## Description

### Technical Field

The present invention relates to the field of materials and devices, and in particular to a high-crystallinity barium titanate film structure, a preparation method therefor and application thereof.

### Background to the Invention

In recent years, non-volatile memory devices have been widely studied. Low-power memory devices with embeddable CMOS circuits are of very high industrial and academic interest.

Non-volatile memory devices include flash memory, magnetic random-access memory (MRAM), resistive RAM, ferroelectric RAM (FeRAM), phase-change RAM (PCRAM) etc. They all have advantages and disadvantages, but the most promising non-volatile memory technologies and low-power operation rely on a ferroelectric layer. In such devices, the binary "0" and "1" are represented by two different stable polarizations in the ferroelectric layer. The main limitation to the use of such devices in embedded environments is the dependence on high temperature (>600°C) annealing to obtain a high-quality ferroelectric layer.

Barium titanate (BaTiO₃, BTO) is a well-known ferroelectric material. Due to its large dielectric constant, moderate coercive field, and higher ferroelectric phase change temperature than room temperature, barium titanate has been extensively studied in many electronic applications. Therefore, BTO is a very important and suitable material to use as a dielectric layer in various storage devices ranging from DRAM to FeRAM and FE-FETs.

Crystalline BTO films have better properties than amorphous films. One of the methods to obtain the crystalline BTO films is to grow them at a high temperature of 600-700°C or above by physical vapor deposition, for example, molecular beam epitaxy (MBE)/pulsed laser deposition (PLD)/magnetron sputtering. Thermal annealing at a higher temperature after growth is also an effective method, which, however, is not suitable for back-end-of-line (BEOL) integration processes.

In recent years, atomic layer deposition (ALD) has emerged as a favourable growth technique due to low growth temperature, good uniformity, precise stoichiometry control, and homogenous step and 3D coverage for applications with a high aspect ratio. In general, BTO films grown by ALD are still amorphous. Therefore, a method for obtaining a high-crystallinity BTO film at a low temperature is desired for the back-end-of-line (BEOL) integrated processes.

Aspects and embodiments of the present invention have been devised with the foregoing in mind.

### Summary of the Invention

In order to overcome the above technical defects, an object of the present invention is to provide a high-crystallinity barium titanate (BTO) film or film structure, a method of preparation and an application therefor, in order to solve the problem that the existing method for producing crystalline BTO films is not applicable to the back-end-of-line (BEOL) integration processes.

According to a first aspect of the present invention, there is provided a method of producing a high-crystallinity barium titanate file or film structure, comprising depositing, on a base material or substrate, a barium titanate (BTO) layer with a (001) or (111) crystal orientation by atomic layer deposition in a high vacuum environment and at a low temperature of 450°C or below, and performing plasma annealing treatment on the barium titanate layer at a low temperature of 450°C or below without breaking vacuum so as to crystallise the BTO layer and form a high-crystallinity barium titanate layer having the (001) or (111) crystal orientation.

The invention provides a method of producing high crystallinity BTO layers at low temperature that is compatible with the back-end-of-line integration and CMOS processes and thus solves the problem with prior art processes.

In the context of the present invention, the BTO "film structure" comprises at least a high-crystallinity BTO layer, and may further comprise one or more additional functional layers formed in various positions in a layered structure, such as one or more electrode layers, as is required by the end application. A high vacuum environment may be defined as within a vacuum chamber having a base vacuum pressure of less than 10⁻⁷ Torr (1.33 10⁻⁷ mBar) (before any processing is commenced).

Preferably, a Ba/Ti ratio in the barium titanate layer is in the range 0.9-1.5.

The method may further comprise forming a top electrode layer on the barium titanate layer. Alternatively, the method may further comprise forming a metal nitride layer and/or a metal alloy layer on the barium titanate layer, and forming a top electrode layer on the metal nitride layer and/or the metal alloy layer. Where both a metal nitride layer and a metal alloy layer are formed on the BTO layer, these may be provided in any order.

Optionally or preferably, the top electrode layer, metal nitride layer and/or the metal alloy layer are formed by sputtering, such as magnetron sputtering. Preferably, the steps of BTO deposition, annealing, forming the top electrode layer, and where present forming the metal nitride layer and/or the metal alloy layer, are performed in a high vacuum environment and without breaking vacuum.

Preferably, the metal nitride layer or the metal alloy layer has a thickness in the range of 10-50 nm.

Preferably, the metal nitride layer is provided as Mn₃AN or CusPdN, wherein A comprises Ni, Sn, Ga, Cu or Pt. The metal alloy layer may be provided as CusPd, PtsNi, Pt₃Fe or Pt₃Al.

Preferably, the top electrode layer is provided as a conductive layer formed of or comprising Pt, Ta, TaN, TiN, Au or Ag.

The method may further comprise, forming a bottom electrode layer on the substrate or base material before depositing the barium titanate layer.

Preferably, the bottom electrode is formed by sputtering, such as magnetron sputtering. Preferably, the steps of forming the bottom electrode layer, BTO deposition and annealing and are carried out in a high vacuum environment and without breaking vacuum.

Preferably, the bottom electrode layer is a conductive layer formed of or comprising at one of the following: Pt, Au, Ag, conductive oxide, metal nitride or metal alloy, having a (001), (111) or mixed crystal orientation.

Preferably, the bottom electrode layer has a thickness in the range of 10-50 nm and a roughness of less than 1 nm. The roughness may be RA or RMS roughness, as measured over a 5 × 5 micron area by atomic force microscopy (AFM).

Preferably, the deposition of the barium titanate layer and the plasma annealing treatment is performed in a vacuum chamber with a base vacuum pressure of less than 10⁻⁷ Torr (1.33 10⁻⁷ mBar).

Preferably, the plasma annealing is performed with a gas source of an inert gas and oxygen at a ratio in the range of 1: 19-4: 1. Preferably, the plasma annealing treatment is performed for a period of 1-6 hours at a set temperature of 300-450°C with a power (i.e. an RF plasma power) of 200-400 W. The temperature may be the substrate temperature.

Preferably, the substrate or base material comprises or is formed of a silicon plate, sapphire, magnesium oxide with a (001) or (110) crystal orientation, or silicon carbide with a (0001) crystal orientation. The method may include a step of providing a silicon plate, sapphire, magnesium oxide with a (001) or (110) crystal orientation, or silicon carbide with a (0001) crystal orientation as the substrate or base material.

Preferably, the barium titanate layer is deposited with a thickness in the range of 1-10 nm.

Preferably, all the method steps are performed in a vacuum chamber within a high vacuum environment defined by a base vacuum pressure of less than 10⁻⁷ Torr (1.33 10⁻⁷ mBar), without breaking vacuum between steps. Accordingly, the method may further comprise, before each processing step described above, a step of pumping the vacuum chamber down to the base vacuum pressure. The steps of the method may be performed in the same vacuum chamber, or in one or more interconnected vacuum chambers.

According to a second aspect of the invention, there is provided a use of a high-crystalline barium titanate film structure obtained by the method of the first aspect in any one or more of: a ferroelectric element, a ferroelectric tunnel junction, an energy storage element, a magnetic tunnel junction, a storage element and a supercapacitor.

According to a third aspect of the invention, there is provided a high-crystallinity barium titanate film structure produced by the method of the first aspect.

According to a fourth aspect of the invention, there is provided a high-crystallinity barium titanate (BTO) film structure, comprising: a substrate or base material comprising or formed of silicon, sapphire, magnesium oxide with a (001) or (110) crystal orientation, or silicon carbide with a (0001) crystal orientation; a high-crystallinity barium titanate layer having a Ba/Ti ratio in the range 0.9-1.5; and a top electrode layer comprising or formed of Pt, Ta, TaN, TiN, Au or Ag, wherein the barium titanate layer is arranged on the substrate, and the top electrode layer is located on a side of the barium titanate layer facing away from the substrate material; wherein the barium titanate layer has a (001) or (111) crystal orientation and is deposited at a low temperature of 450°C or below through atomic layer deposition; and wherein the barium titanate layer is subjected to plasma annealing treatment in vacuum.

Preferably, the BTO film structure further comprises a bottom electrode layer arranged between the substrate (or base material) and the barium titanate layer, and wherein the bottom electrode layer is provided as a Pt layer, Au layer, Ag layer, conductive oxide layer, metal nitride layer or metal alloy layer, having a (001), (111) or mixed crystal orientation.

Preferably, the BTO film structure further comprises a metal nitride layer and/or metal alloy layer arranged between the barium titanate layer and the top electrode layer. The metal nitride layer may be provided as Mn₃AN or CusPdN, wherein A comprises Ni, Sn, Ga, Cu or Pt, and the metal alloy layer may be provided as CusPd, PtsNi, Pt₃Fe or PtsAl.

The present application discloses a high-crystallinity barium titanate film or film structure, including a base material, a barium titanate layer and a top electrode layer, wherein the barium titanate layer is arranged on the base material, and the top electrode layer is located on a side of the barium titanate layer away from the base material; the base material is provided as a silicon plate, sapphire, magnesium oxide with a (001) or (110) crystal orientation or silicon carbide with a (0001) crystal orientation; the barium titanate layer has a (001) or (111) crystal orientation and grows at a low temperature of 450°C or below through atomic layer deposition; the barium titanate layer is subjected to plasma annealing in vacuum; a Ba/Ti ratio in the barium titanate layer is 0.9-1.5; and the top electrode layer is provided as a conductive layer formed by Pt, Ta, TaN, TiN, Au or Ag.

Preferably, a bottom electrode layer is arranged between the base material and the barium titanate layer; and the bottom electrode layer is provided as a Pt layer, Au layer, Ag layer, conductive oxide layer, metal nitride layer or metal alloy layer, having a (001), (111) or mixed crystal orientation.

Preferably, a metal nitride layer or metal alloy layer is arranged between the barium titanate layer and the top electrode layer. The metal nitride layer is provided as Mn₃AN or CusPdN, with A including Ni, Sn, Ga, Cu or Pt; and the metal alloy layer is provided as CusPd, CusPdN, PtsNi, Pt₃Fe or PtsAl.

Also disclosed is a preparation method for a high-crystallinity barium titanate film for preparation of the barium titanate film defined in any item above. The preparation method includes: step 1: providing a silicon plate, sapphire, magnesium oxide with a (001) or (110) crystal orientation or silicon carbide with a (0001) crystal orientation, as a base material; step 2: performing low-temperature growth and plasma annealing treatment in a crystal growth direction in a high vacuum environment of a plasma chamber based on an atomic layer deposition system, to form a barium titanate layer having a (001) or (111) crystal orientation, wherein a Ba/Ti ratio in the barium titanate layer is 0.9-1.5; and step 3: performing vacuum magnetron sputtering on the barium titanate layer to form a top electrode layer.

Preferably, before step 2, the preparation method further includes: performing ultrahigh-vacuum magnetron sputtering on the base material to form a bottom electrode layer, wherein the bottom electrode layer is provided as a Pt layer, Au layer, Ag layer, conductive oxide layer, metal nitride layer or metal alloy layer, having a (001), (111) or mixed crystal orientation.

Preferably, the base vacuum pressure of the plasma chamber in step 2 is less than 10⁻⁷ Torr (1.33 10⁻⁷ mBar), a gas source is a mixed gas of an inert gas and oxygen at a ratio of 1: 19-4: 1. Preferably, the plasma annealing in step 2 is performed for 1-6 hours at a set temperature of 300-450°C with a power of 200-400 W.

Preferably, the bottom electrode layer has a thickness of 10-50 nm and a roughness of less than 1 nm; and the barium titanate layer has a thickness of 1-10 nm.

Preferably, before performing sputtering to form the top electrode layer in step 3, vacuum magnetron sputtering is performed on the barium titanate layer to form a metal nitride layer or metal alloy layer; and the metal nitride layer or the metal alloy layer has a thickness of 10-50 nm.

Also disclosed is an application of the barium titanate film obtained by the preparation method described above in ferroelectric elements, ferroelectric tunnel junctions, energy storage elements, magnetic tunnel junctions, storage elements or supercapacitors.

After the above technical solutions are adopted, the present invention has the following beneficial effects compared with the prior art: the present invention provides the preparation method for and application of the high-crystallinity barium titanate film or film structure (where the high-crystallinity barium titanate film structure includes a base material, an optional bottom electrode layer, a barium titanate layer, an optional metal nitride layer or metal alloy layer, and an optional top electrode layer); whereby a barium titanate crystalline film or film structure is deposited by atomic layer deposition and crystallized by direct plasma annealing at low temperature, to form a barium titanate layer with high crystallinity at low temperature; and the preparation process is carried out under high vacuum, such that the problem that the existing methods for producing crystalline BTO films is not applicable to the back-end-of-line integration processes is solved.

Features which are described in the context of separate aspects and embodiments of the invention may be used together and/or be interchangeable. Similarly, where features are, for brevity, described in the context of a single embodiment, these may also be provided separately or in any suitable sub-combination. Features described in connection with the device may have corresponding features definable with respect to the method(s), and vice versa, and these embodiments are specifically envisaged.

### Brief Description of Drawings

In order that the invention can be well understood, embodiments will now be discussed by way of example only with reference to the accompanying drawings, in which:
**FIGs. 1(a) to 1(e)** show schematic structural diagrams of examples of a high-crystallinity barium titanate film structure according to an embodiment of the present invention;
**FIG. 2** is a flow chart of a method of producing a high-crystallinity barium titanate film structure according to an embodiment of the present invention;
**FIG. 3** is a schematic structural diagram of a plasma chamber for producing a high-crystallinity barium titanate film structure according to an embodiment of the present invention;
**FIG. 4** is an XRD diagram of a barium titanate film structure with a structure of FIG. 1(d) obtained by the method in FIG. 2 for a high-crystallinity barium titanate film;
**FIG. 5** is an XPS spectrum of a barium titanate film structure obtained by the method in FIG. 2 for a high-crystallinity barium titanate film; and
**FIG. 6** is a TEM diagram of barium titanate films of different thicknesses as prepared by the method in FIG. 2 for the high-crystallinity barium titanate film.

It should be noted that the figures are diagrammatic and may not be drawn to scale. Relative dimensions and proportions of parts of these figures may have been shown exaggerated or reduced in size, for the sake of clarity and convenience in the drawings.

The same reference signs are generally used to refer to corresponding or similar features in modified and/or different embodiments.

### Detailed Description

The advantages of the present invention will be further set forth below in conjunction with the accompanying drawings and specific embodiments.

Reference will now be made in detail to exemplary embodiments, examples of which are illustrated in the accompanying drawings. The following description refers to the accompanying drawings in which the same numbers in different drawings represent the same or similar elements unless otherwise indicated. The implementations set forth in the following description of exemplary embodiments do not represent all implementations consistent with the present disclosure. Instead, they are merely examples of apparatuses and methods consistent with aspects related to the disclosure as recited in the appended claims.

The terms used in the present disclosure are for the purpose of describing particular embodiments only and are not intended to limit the present disclosure. The singular forms "a/an", "said" and "the" used in the present disclosure and the appended claims are intended to include the plural forms as well, unless the context clearly indicates otherwise. It should also be understood that the term "and/or" as used herein refers to and includes any or all possible combinations of one or more associated listed items. It should be understood that although the terms first, second, third, etc. may be used to describe various information, which, however, should not be limited to these terms. These terms are only used to distinguish the information of the same type. Similarly, without departing from the scope of the present disclosure, the first information may be also called second information, and similarly, the second information may also be called first information. Depending on the context, the word "if" as used herein can be interpreted as "while" or "when" or "in response to determination".

In the description of the present invention, it should be understood that terms such as "longitudinal", "horizontal", "upper", "lower", "left", "right", "right", "vertical", "horizontal", "top", "bottom", "inner" and "outside" indicate directions or positional relations based on the directions or position relations as shown in the accompanying drawings only for the purposes of describing the present invention and simplifying the description, instead of indicating or implying that a referred device or element must have a specific direction or must be constructed and operated in a specific direction. Therefore, these terms should not be construed as limiting the present invention.

In the description of the present invention, it should be noted that, unless otherwise specified and defined, the terms "install", "connect", and "couple" should be understood in a broad sense. For example, a connection may be a mechanical connection or an electrical connection, or an internal communication between two elements, or may be a direct connection, or an indirect connection via an intermediate medium. The specific meanings of the terms above can be understood depending on specific conditions for those of ordinary skills in the art.

In subsequent descriptions, the use of suffixes such as "module", "component" or "unit" for denoting elements is only intended to facilitate the description of the present invention, and has no specific meaning in itself. Therefore, "module" and "component" can be used interchangeably.

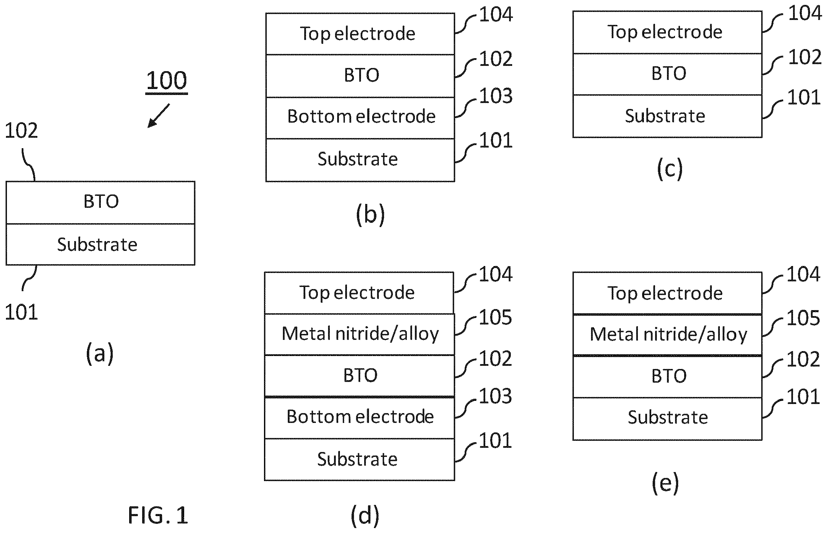

FIGs. 1(a)-1(e) show examples of a high-crystallinity barium titanate (BTO) film structure 100 according to embodiments of the invention. Referring to the example in FIG. 1(a), the BTO film structure 100 includes a substrate (base material) 101 and a barium titanate layer (barium titanate crystalline film, BTO) 102. Referring to the example in FIG. 1(b), the BTO film structure 100 includes a substrate (base material) 101, a bottom electrode layer 103, a barium titanate layer (barium titanate crystalline film, BTO) 102 and a top electrode layer 104, without the provision of a metal nitride layer or metal alloy layer 105. The example in FIG. 1(c) includes a substrate 101, a barium titanate layer 102 (barium titanate crystalline film, BTO) and a top electrode layer 104, without the provision of a bottom electrode layer 103 and a metal nitride layer or metal alloy layer. Referring to the example in FIG. 1(d), the BTO film structure 100 includes a substrate 101, a bottom electrode layer 103, a barium titanate layer 102 (barium titanate crystalline film, BTO), a metal nitride layer or metal alloy layer 105, and a top electrode layer 104. The example in FIG. 1(e) includes a substrate 101, a barium titanate layer 102, a metal nitride layer and/or a metal alloy layer 105, and a top electrode layer 104, without the provision of a bottom electrode layer 103 but with the provision of the metal nitride layer and/or the metal alloy layer 105.

Specifically, on the basis of FIGs. 1(c) and 1(e), the barium titanate layer 102 is arranged on the base material (i.e., substrate) 101, and the top electrode layer 104 is located on a side of the barium titanate layer 102 facing away from the base material 101. The base material 101 is provided as a silicon plate, sapphire, magnesium oxide having a (001) or (110) crystal orientation or silicon carbide having a (0001) crystal orientation. The barium titanate layer 102 has a (001) or (111) crystal orientation and grows at a low temperature of 450°C or below through atomic layer deposition; with a Ba/Ti ratio in the barium titanate layer is 0.9-1.5. The top electrode layer 104 includes a conductive layer of Pt, Ta, TaN, TiN, Au, Ag or others having high conductivity.

As a supplement, the above-mentioned barium titanate layer 102 grows at a low temperature (< 450°C) by atomic layer deposition, and is subjected to direct plasma annealing in a vacuum chamber after BTO crystal growth. All manufacturing processes are carried out under high vacuum. In addition to the base material 101 and a top electrode 104, the following additional materials (such as the bottom electrode 103 layer or metal nitride, metal alloys 105 or the like described below) have similar lattice constants, and the specific value of the Ba/Ti ratio in the barium titanate layer 102 can be measured by X-ray photoelectron spectroscopy (XPS).

In this embodiment, the barium titanate (BTO) layer 102 is deposited through atomic layer deposition (ALD). It is crystallized by direct plasma annealing at a low temperature. With this method, a high-crystallinity ferroelectric BTO layer 102 can be obtained at 450°C, which can be widely used in supercapacitors, memory devices, field effect transistors, MEMS and other applications. Due to its relatively low process temperature, this method is compatible with CMOS processes.

Specifically, referring to FIG. 1(b) and (d), the bottom electrode layer 103 is arranged between the base material 101 and the barium titanate layer 102. In a preferred example, the bottom electrode layer 103 is provided as a Pt layer, Au layer, Ag layer, conductive oxide layer, metal nitride layer or metal alloy layer, having a (001), (111) or mixed crystal orientation.

Specifically, referring to FIG. 1(d) and (e), the metal nitride layer or metal alloy layer 105 is arranged between the barium titanate layer 104 and the top electrode layer 104.

In a preferred example, the metal nitride layer 105 is provided as Mn₃AN or Cu₃PdN, with A including Ni, Sn, Ga, Cu or Pt, and the metal alloy layer 105 is provided as Cu₃Pd, PtsNi, Pt₃Fe or PtsAl. At the top of the barium titanate layer 102, one metal nitride layer 105 and/or one metal alloy layer 105 is arranged between the barium titanate layer 102 and the top electrode layer 104, and only one metal electrode stack layer or metal electrode (i.e., the top electrode 104 described above) is provided. Then, one tunnel junction unit or capacitor unit can be formed for the complete structure, which can be used in fields such as supercapacitors, field-effect transistors, memory devices, tunnel junctions, magnetoelectric coupling devices, and switchable photovoltaic and ferroelectric devices.

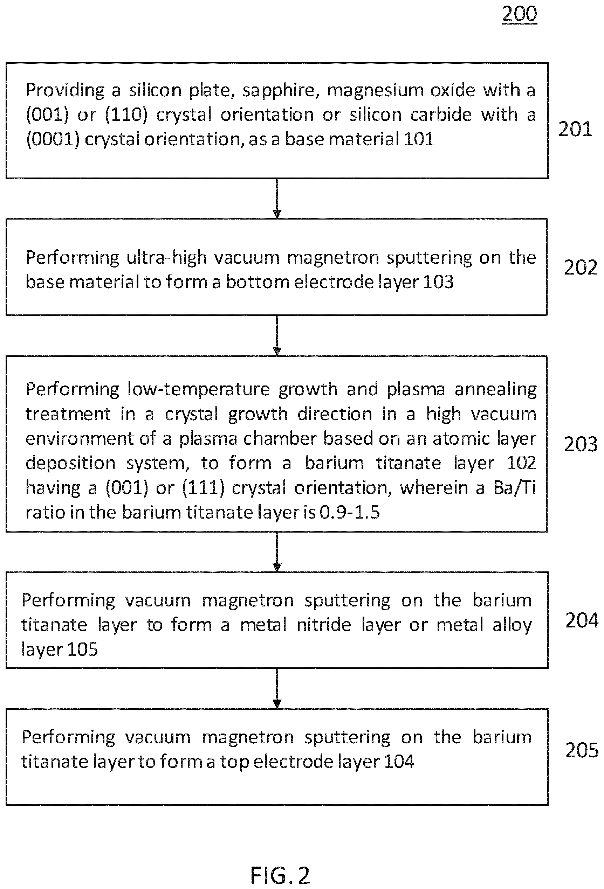

The present invention further provides a method 200 of producing or preparing the high-crystallinity barium titanate film structure described above. Referring to FIG. 2, an embodiment of the method 200 includes the following steps.

In step 201, a silicon plate, sapphire, magnesium oxide with a (001) or (110) crystal orientation or silicon carbide with a (0001) crystal orientation is provided as a base material (substrate) 101.

In step 203, low-temperature plasma annealing treatment is performed in a crystal growth direction in a high vacuum environment of a plasma chamber based on an atomic layer deposition system, to form a barium titanate layer 102 having a (001) or (111) crystal orientation, with a Ba/Ti ratio of 0.9-1.5 in the barium titanate layer 102.

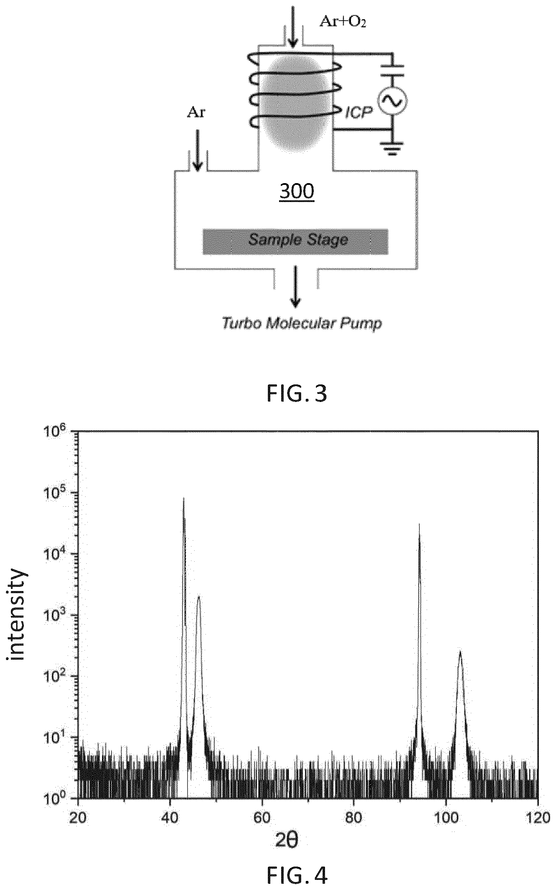

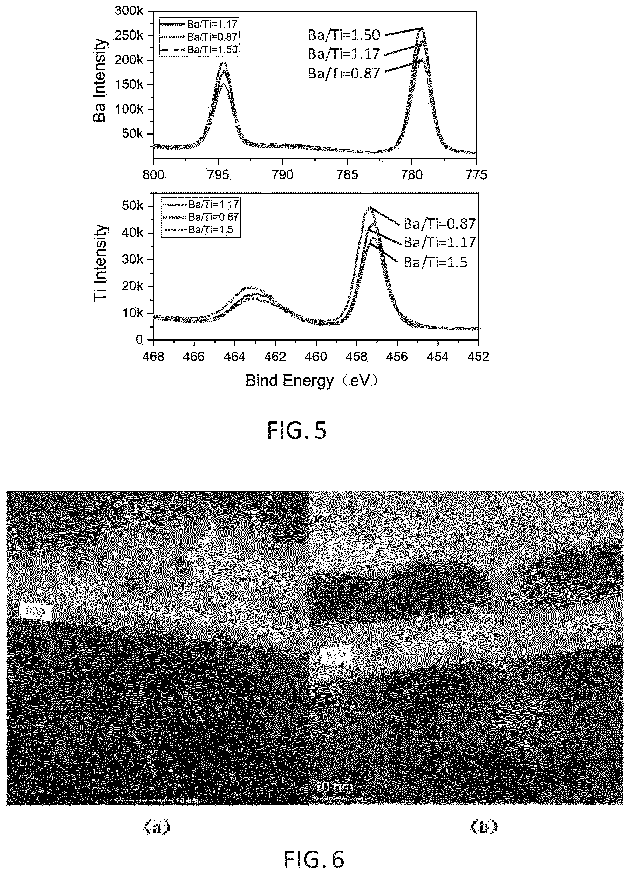

In the above-mentioned step 203, the BTO layer or film 102 having the (001) or (111) crystal orientation is deposited in the plasma chamber (i.e., an annealing chamber 300, as shown in FIG. 3) by a plasma-enhanced ALD system, with 0.9≤x≤1.5 (x representing the Ba/Ti ratio in the BTO layer 102). For ordinary BTO, the ratio x is equal to 1. As shown in FIG. 5, the X-ray photoelectron spectroscopy (XPS) spectrum shows different Ba/Ti ratios of three BTO layers or films 102. During the BTO crystal growth process in step 203 mentioned above, the ratio is changed by adjusting the cycle ratios of Ba-O and Ti-O. After growth, the BTO layer 102 is subjected to direct plasma annealing treatment in a normal direction without breaking the vacuum, thereby obtaining a barium titanate layer 102 with high crystallinity at a low temperature.

Specifically, the base vacuum pressure of the plasma chamber in step 203 is lower than 10⁻⁷ Torr (1.33 10⁻⁷ mBar). A gas source in the plasma chamber includes two parts: a plasma gas and a carrier gas, and the plasma source is a mixed gas of an inert gas (preferably, argon) and oxygen. The carrier gas is argon (Ar). Therefore, the gas source may be a mixed gas of argon and oxygen at a ratio of 1:19 to 4:1.

As an interpretation, the percentage of crystallization area increases with the increase of annealing power. Obviously, the power provides energy for Ar ions and contributes to the local annealing temperature. On the other hand, however, the BTO layer 102 may be damaged under too high power. For a given annealing temperature, annealing time, Ba/Ti ratio and BTO thickness, the power should be limited, for which the annealing temperature is also an important factor. Therefore, the plasma annealing in step 203 is performed for 1-6 Hours at a set temperature of 300-450°C with a power of 200-400 W. It is worth noting that the annealing power is inversely proportional to the annealing temperature. The power range in the present invention is only for better application of this embodiment, since different models of apparatuses may have different power ranges. The crystallinity of the BTO layer 102 increases with the extension of annealing time.

Before the above-mentioned step 203 of deposition to obtain the barium titanate layer 102, the method 200 may further include step 202: performing ultrahigh-vacuum magnetron sputtering on the base material 101 to form a bottom electrode layer 103. The bottom electrode layer 104 is preferably provided as a Pt layer, Au layer, Ag layer, conductive oxide layer, metal nitride layer or metal alloy layer 105, having a (001), (111) or mixed crystal orientation. Before the above-mentioned high-vacuum magnetron sputtering for the bottom electrode layer 103, the method 200 may further include: cleaning the base material 101 with an ultrasonic bath using acetone, isopropanol and deionized water; or before that, cleaning the base material 101 by etching with a strong acid (HF) or reactive ion etching. That is, the base material 101 is cleaned before the bottom electrode layer 103 is formed by sputtering, thereby reducing the problem that the dust on the base material 101 substrate leads to bubbles or unevenness formed on the bottom electrode layer 103 to affect the subsequent application in semiconductor elements.

In this example embodiment, the above-mentioned bottom electrode layer 103 has a thickness of 10-50 nm and a roughness of less than 1 nm; and the thickness of the barium titanate layer is 1-10 nm. The roughness may be average roughness (RA roughness) or root mean squared roughness (RMS roughness), as measured over a 5 × 5 micron area by atomic force microscopy (AFM). As an illustration, the thickness of BTO layer 102 has a certain effect on a crystallization region formed by annealing. As shown in FIG. 6, which shows the TEM (transmission electron microscopy) results after annealing of BTO layers 102 of different thicknesses produced by the above method 200. Here, FIG. 6(a) shows a BTO layer 102 with a thickness of 3.2 nm and FIG. 6(b) shows a BTO layer 102 with a thickness of 8-9 nm. It can be seen that the crystallized BTO layer 102 can be obtained by the above-mentioned preparation method 200.

After deposition and annealing of the barium titanate layer 102, the method 200 may further include step 205. In step 205, vacuum magnetron sputtering is performed on the barium titanate layer 102 to form a top electrode layer 104.

Additionally, before performing sputtering to form the top electrode layer 104 in step 205, the method 200 may further include step 204: performing vacuum magnetron sputtering on the barium titanate layer 102 to form a metal nitride layer or metal alloy layer 105. The metal nitride layer or metal alloy layer 105 has a thickness of 10-50 nm.

In this embodiment, the base vacuum pressure of the sputtering system is lower than 10⁻⁷ Torr (1.33 ×10⁻⁷ mBar).

Preferably, all the method steps are performed in a vacuum chamber within a high vacuum environment defined by a base vacuum pressure of less than 10⁻⁷ Torr (1.33 10⁻⁷ mBar), without breaking vacuum between steps. Accordingly, the method 200 may further comprise, before each processing step described above, a step of pumping the vacuum chamber down to the base vacuum pressure. The steps of the method 200 may be performed in the same vacuum chamber, or in one or more interconnected vacuum chambers (e.g. different vacuum chambers interconnected by a vacuum tube).

Although the bottom electrode layer 103, top electrode layer 104 and metal nitride layer or metal alloy layer 105 are described above as being deposited by sputtering, it will be appreciated that alternative physical or chemical vapour deposition techniques known in the art may instead be used.

As a further illustration, the X-ray diffraction (XRD) θ-2θ scan for a device sample of the BTO film structure 100 produced by the above method 200 is measured on a Bruker X-ray diffractometer. The XRD results are shown in FIG. 4, in which the sample (film structure 100) used has a structure as shown in FIG. 1(d), specifically showing strong (002) and (004) peaks and no other peaks, whereby it is determined that a high-crystallinity barium titanate layer 102 is formed. The X-ray photoelectron spectroscopy is used to measure the composition in the BTO layer 102.

The present invention further provides an application of the barium titanate film structure 100 obtained by the above-mentioned method 200 in ferroelectric elements, ferroelectric tunnel junctions, energy storage elements, magnetic tunnel junctions, storage elements or supercapacitors. Specifically, an element including the film may be used as a ferroelectric element, a ferroelectric tunnel junction, an energy storage element, a magnetic tunnel junction, a storage element or a supercapacitor. Hence, the element formed from the film can be widely used in fields such as supercapacitors, field-effect transistors, storage devices, tunnel junctions, magnetoelectric coupling devices, switchable photovoltaic and ferroelectric devices.

It should be noted that the above embodiments of the present invention are not intended to limit the scope of the present invention in any form. Without departing from the content of the technical solutions of the present invention, any person familiar with the art may alter or modify the above disclosed technical content into equivalent valid embodiments. Any alternation or equivalent variation and modification made to the above embodiments according to the technical essence of the present invention shall still fall within the scope of the technical solutions of the present invention

The following clauses, which are not claims, define optional or preferred features of the present disclosure.

Clause 1. A high-crystallinity barium titanate film, comprising a base material, a barium titanate layer and a top electrode layer, wherein the barium titanate layer is arranged on the base material, and the top electrode layer is located on a side of the barium titanate layer away from the base material; the base material is provided as a silicon plate, sapphire, magnesium oxide with a (001) or (110) crystal orientation or silicon carbide with a (0001) crystal orientation; the barium titanate layer has a (001) or (111) crystal orientation and grows at a low temperature of 450°C or below through atomic layer deposition; the barium titanate layer is subjected to plasma annealing in vacuum; a Ba/Ti ratio in the barium titanate layer is 0.9-1.5; and the top electrode layer is provided as a conductive layer formed by Pt, Ta, TaN, TiN, Au or Ag.

Clause 2. The barium titanate film according to clause 1, wherein a bottom electrode layer is arranged between the base material and the barium titanate layer; and the bottom electrode layer is provided as a Pt layer, Au layer, Ag layer, conductive oxide layer, metal nitride layer or metal alloy layer, having a (001), (111) or mixed crystal orientation.

Clause 3. The barium titanate film according to clause 1, wherein a metal nitride layer or metal alloy layer is arranged between the barium titanate layer and the top electrode layer; and the metal nitride layer is provided as Mn₃AN or CusPdN, wherein A comprises Ni, Sn, Ga, Cu or Pt, and the metal alloy layer is provided as CusPd, PtsNi, Pt₃Fe or PtsAl.

Clause 4. A preparation method for a high-crystallinity barium titanate film for use in preparation of the barium titanate film according to any one of clause 1 to 3, comprising: step 1: providing a silicon plate, sapphire, magnesium oxide with a (001) or (110) crystal orientation or silicon carbide with a (0001) crystal orientation, as a base material; step 2: performing low-temperature plasma annealing treatment in a crystal growth direction in a high vacuum environment of a plasma chamber based on an atomic layer deposition system, to form a barium titanate layer having a (001) or (111) crystal orientation, wherein a Ba/Ti ratio in the barium titanate layer is 0.9-1.5; and step 3: performing vacuum magnetron sputtering on the barium titanate layer to form a top electrode layer.

Clause 5. The preparation method according to clause 4, wherein before step 2, the preparation method further comprises: performing ultrahigh-vacuum magnetron sputtering on the base material to form a bottom electrode layer, wherein the bottom electrode layer is provided as a Pt layer, Au layer, Ag layer, conductive oxide layer, metal nitride layer or metal alloy layer, having a (001), (111) or mixed crystal orientation.

Clause 6. The preparation method according to clause 4, wherein base vacuum pressure of the plasma chamber in step 2 is less than 10⁻⁷ Torr, a gas source is a mixed gas of an inert gas and oxygen at a ratio of 1: 19-4: 1.

Clause 7. The preparation method according to clause 4, wherein the plasma annealing in step 2 is performed for 1-6 Hours at a set temperature of 300-450°C with a power of 200-400 W.

Clause 8. The preparation method according to clause 4, wherein before performing sputtering to form the top electrode layer in step 3, vacuum magnetron sputtering is performed on the barium titanate layer to form a metal nitride layer or metal alloy layer; and the metal nitride layer or the metal alloy layer has a thickness of 10-50 nm.

Clause 9. The preparation method according to clause 5, wherein the bottom electrode layer has a thickness of 10-50 nm and a roughness of less than 1 nm; and the barium titanate layer has a thickness of 1-10 nm.

Clause 10. Application of the barium titanate film obtained by the preparation method according to any one of clauses 4-9 in ferroelectric elements, ferroelectric tunnel junctions, energy storage elements, magnetic tunnel junctions, storage elements or supercapacitors.

From reading the present disclosure, other variations and modifications will be apparent to the skilled person. Such variations and modifications may involve equivalent and other features which are already known in the art, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub-combination.

For the sake of completeness it is also stated that the term "comprising" does not exclude other elements or steps, the term "a" or "an" does not exclude a plurality, and any reference signs in the claims shall not be construed as limiting the scope of the claims.

## Claims

1. A method of producing a high-crystallinity barium titanate film structure, comprising:
depositing, on a substrate, a barium titanate layer with a (001) or (111) crystal orientation by atomic layer deposition in a high vacuum environment and at a low temperature of 450°C or below, wherein a Ba/Ti ratio in the barium titanate layer is 0.9-1.5; and
performing plasma annealing treatment on the barium titanate layer at a low temperature of 450°C or below without breaking vacuum to form a high-crystallinity barium titanate layer having the (001) or (111) crystal orientation.

2. The method of claim 1, further comprising:
forming a top electrode layer on the barium titanate layer, optionally or preferably, by sputtering.

3. The method of claim 1, further comprising:
forming a metal nitride layer or a metal alloy layer on the barium titanate layer;
and
forming a top electrode layer on the metal nitride layer or the metal alloy layer, and optionally or preferably,
wherein the top electrode layer and the metal nitride layer or the metal alloy layer are formed by sputtering.

4. The method of claim 3, wherein the metal nitride layer is provided as Mn₃AN or CusPdN, wherein A comprises Ni, Sn, Ga, Cu or Pt; and wherein the metal alloy layer is provided as Cu₃Pd, Pt₃Ni, Pt₃Fe or Pt₃Al, and/or wherein the metal nitride layer or the metal alloy layer has a thickness of 10-50nm.

5. The method of any of claims 2 to 4, wherein the top electrode layer is provided as a conductive layer formed of Pt, Ta, TaN, TiN, Au or Ag.

6. The method of any preceding claim, wherein, before depositing the barium titanate layer, the method further comprises:
forming a bottom electrode layer on the substrate, optionally or preferably, by sputtering.

7. The method of claim 6, wherein the bottom electrode layer is provided as a Pt layer, Au layer, Ag layer, conductive oxide layer, metal nitride layer or metal alloy layer, having a (001), (111) or mixed crystal orientation.

8. The method of claim 6 or 7, wherein the bottom electrode layer has a thickness of 10-50 nm and a roughness of less than 1 nm, and/or wherein the barium titanate layer has a thickness of 1-10 nm.

9. The method of any preceding claim, wherein the plasma annealing treatment is performed in a vacuum chamber with a base vacuum pressure of less than 10⁻⁷ Torr, and with a gas source of an inert gas and oxygen at a ratio of 1:19-4:1; and/or
wherein the deposition of the barium titanate layer is performed in a vacuum chamber with a base vacuum pressure of less than 10⁻⁷ Torr.

10. The method of any preceding claim, wherein the plasma annealing treatment is performed for 1-6 Hours at a set temperature of 300-450°C and with a power of 200-400 W.

11. The method of any preceding claim, wherein the method steps are performed in one or more vacuum chambers without breaking vacuum; and/or wherein the substrate comprises or is formed of a silicon plate, sapphire, magnesium oxide with a (001) or (110) crystal orientation, or silicon carbide with a (0001) crystal orientation.

12. Use of a high-crystalline barium titanate film structure obtained by the method according to any one of claims 1 to 11 in any one or more of: a ferroelectric element, a ferroelectric tunnel junction, an energy storage element, a magnetic tunnel junction, a storage element and a supercapacitor.

13. A high-crystallinity barium titanate film structure produced by the method of any of claims 1 to 11.

14. A high-crystallinity barium titanate film structure, comprising:
a substrate comprising or formed of silicon, sapphire, magnesium oxide with a (001) or (110) crystal orientation, or silicon carbide with a (0001) crystal orientation;
a high-crystallinity barium titanate layer having a Ba/Ti ratio in the range 0.9-1.5; and
a top electrode layer comprising or formed of Pt, Ta, TaN, TiN, Au or Ag,
wherein the barium titanate layer is arranged on the substrate, and the top electrode layer is located on a side of the barium titanate layer facing away from the substrate material;
wherein the barium titanate layer has a (001) or (111) crystal orientation and is deposited at a low temperature of 450°C or below through atomic layer deposition; and
wherein the barium titanate layer is subjected to plasma annealing treatment in vacuum.

15. The barium titanate film structure according to claim 14, further comprising:
a bottom electrode layer arranged between the substrate and the barium titanate layer, and wherein the bottom electrode layer is provided as a Pt layer, Au layer, Ag layer, conductive oxide layer, metal nitride layer or metal alloy layer, having a (001), (111) or mixed crystal orientation; and/or
a metal nitride layer or metal alloy layer arranged between the barium titanate layer and the top electrode layer; and wherein the metal nitride layer is provided as Mn₃AN or CusPdN, wherein A comprises Ni, Sn, Ga, Cu or Pt, and the metal alloy layer is provided as CusPd, PtsNi, Pt₃Fe or PtsAl.
